# EUROPEAN PATENT APPLICATION

(11) **EP 4 564 424 A1**
(43) Date of publication of application: **04.06.2025**
(21) Application number: 23213658.0
(22) Date of filing: 01.12.2023
(51) Int. Cl.: H01L 23/495, H01L 21/48

(54) **LEAD FRAME**

(71) Applicant: Nexperia B.V., 6534 AB Nijmegen (NL)
(72) Inventor: Yeung, Shun Tik, Hong Kong (HK)
(74) Representative: Pjanovic, Ilija

(57) **Abstract**

There is disclosed a lead frame for a semiconductor assembly. The lead frame comprises a first columnar array of die paddles and a second columnar array of die paddles. The die paddles in the first columnar array are offset from the die paddles in the second columnar array.

## Description

The present invention relates to a lead frame for a semiconductor assembly and a semiconductor assembly.

Semiconductor assemblies, such as transistors, are manufactured as layered assemblies including components such as die paddles, dies, clips and a casing. The casing provides a protective functionality and (at least partly) surrounds the die and other components forming part of the semiconductor assembly. The casing may otherwise be referred to as an encapsulant.

The die paddles are initially manufactured as part of a lead frame. The lead frame consists of a plurality of die paddles (which may be interchangeably referred to as a die pad) generally arranged in columnar arrays. Lead frames are generally manufactured by removing material from a flat plate of copper, copper alloy or an iron nickel alloy, the material is usually removed by etching or stamping. The number of die paddles that can be provided in a single lead frame, is at least in part limited by the size of the initial material (e.g. the plate of copper) and the width of material that must remain between adjacent die paddles so as to provide structure and rigidity to the lead frame, otherwise the lead frame may warp an unacceptable amount and in the worst cases break. However, this material between die paddles is ultimately wasted material as it is generally removed when making individual semiconductor assemblies, it will however be appreciated that a small amount of the material between the die paddles may remain when forming the individual semiconductor assemblies (i.e. following a cutting stage).

There exists a need to overcome one or more of the disadvantages associated with existing semiconductor assemblies and lead frames, whether mentioned in this document or otherwise.

According to a first aspect of the invention there is provided a lead frame for a semiconductor assembly, the lead frame comprising a first columnar array of die paddles and a second columnar array of die paddles;
wherein the die paddles in the first columnar array are offset from the die paddles in the second columnar array.

The lead frame and/or die paddles may be otherwise described as a plate of conductive material. The lead frame and die paddles may be manufactured from a copper alloy or entirely from copper, or from any other suitable material.

The lead frame may be for a leadless packaging such that leads do not extend from the die paddles. In other embodiments, leads may extend from the die paddles.

The term columnar array of die paddles encompasses a plurality of die paddles arranged in a column. That is to say the die paddles are arranged in a 1 by n array. As such the first and second columnar arrays of die paddles define a 2 by n array. The number of die paddles in the first columnar array will generally be equal to the number of die paddles in the second columnar array. However, in some embodiments the number of die paddles in the first columnar array may be different to the number of die paddles in the second columnar array. The first and second columnar arrays are parallel to one another.

The die paddles in the first columnar array are the same as the die paddles in the second columnar array. The die paddles in the first columnar array being offset from the die paddles in the second columnar encompasses die paddles in the second columnar array being translated in a direction parallel to the first columnar array. That is to say that at least one horizontally extending edge (relative to the columnar direction) of a die paddle in the first columnar array is not aligned with at least one horizontally extending edge of a die paddle in the second columnar array. For example, a top edge of a die paddle in the first columnar array is not aligned with the top (or bottom) edge of a die paddle in the second columnar array. The second columnar array may be translated or shifted in a vertical direction relative to the first columnar array such that the die paddles are offset. The die paddles in the first columnar array being offset from the die paddles in the second columnar array is advantageous as it allows the spacing between the two columnar arrays (referred to as the sawlane width) to be reduced. The die paddles in adjacent columnar arrays may be offset by rotating an adjacent columnar arrays through 180 degrees. Reducing the sawlane width is beneficial as it allows the number of die paddles provided on a given sized lead frame to be increased. Put another way, the density of die paddles on a lead frame is increased. Increasing the density of die paddles on a lead frame provides a significant reduction in manufacturing costs.

Each die paddle may undergo further manufacturing to form separate semiconductor assemblies. Increasing the density of die paddles on a lead frame reduces the overall cost of each semiconductor assembly and can result in further cost reductions by reducing the material cost for capsules of the semiconductor assemblies.

Each die paddle may comprise a first pad and a second pad, the first pad may be larger than the second pad, and wherein the first pads in the first columnar array may be offset from the first pads in the second columnar array.

The first pad may be configured to receive a die of a semiconductor assembly. The second pad may be configured to receive a wire connection, for example a wire bond connection. In other embodiments the second pad may be configured to receive metal clip connections or any other suitable type of connections.

The first pads being larger than the second pads encompasses the first pads having a larger surface area than the second pads.

The first pads of the first columnar array being offset from the first pads in the second columnar array encompasses that an upper and lower edge of the first pads in the first columnar array are not aligned with an upper and lower edge of the first pads in the second columnar array. In other words, the first pads (and hence the second pads) in the second columnar array are translated relative to the first pads (and hence the second pads) in the first columnar array.

Each die paddle in the first columnar array may be connected to a die paddle in the second columnar array with a connecting bar.

The term connecting bar encompasses a part of the lead frame that is formed from the same material as the die paddles and provides a mechanical connection between the first and second columnar arrays. The connecting bar provides stability and rigidity to the lead frame. Because the distance between the first columnar array and the second columnar array is reduced, the width of the connecting bars is also reduced, this is beneficial as the rigidity of the lead frame is improved. Improving the rigidity of the lead frame mitigates against warping of the lead frame during further manufacturing processes such as moulding. Being able to reduce warping of the lead frames allows for lead frames of a greater size to be used.

The connecting bars may extend in a direction generally perpendicular to the first and second columnar arrays.

That is to say that the connecting bars extend in a direction that is orthogonal to the direction the die paddles extend in along the length of the columnar array. The connecting bars may be directly attached to the die paddles. However, in other embodiments additional bars, such as tie bars may extend in a generally parallel direction relative to the first and second columnar arrays. In other words, the connecting bars may be perpendicular to the tie bars and to the columnar arrays. The tie bars may be connected to the first and/or the second pads of the die paddles. In addition, tie bars may be connected between the first and second pads of each die paddle to provide a connection.

During further manufacturing when cutting the lead frame to provide individual semiconductor assemblies, the tie bars and/or connecting bars may be cut by a laser.

The connecting bars may extend in a non-parallel and non-perpendicular direction relative to the first and second columnar arrays.

The connecting bars extending in a non-parallel and a non-perpendicular direction relative to the first and second columnar arrays encompasses the connecting bars extending in a diagonal or inclined direction relative to the first and second columnar arrays. In other words, the connecting bars do not extend in a direction that is purely parallel to the first and second columnar arrays, and the connecting bars do not extend in a direction that is purely perpendicular to the first and second columnar arrays. The connecting bars extend in a direction that comprises a parallel and a perpendicular component.

Having diagonal connecting bars is advantageous because it allows the width (the saw lane width) between the first columnar array and the second columnar array to be reduced. Reducing the saw lane width allows for an increased density of die paddles on the lead frame, thus making the lead frame more cost effective. In addition to increasing the density of die paddles for a given sized lead frame the diagonal connecting bars increase the rigidity of the lead frame, which mitigates against warping of the lead frame during further manufacturing steps. Being able to reduce warping of the lead frames allows for lead frames of a greater size to be used.

The diagonal connecting bars may be directly connected to the die paddles. That is to say that the connecting bars need not be connected to the die paddles via additional connections such as tie bars.

Each connecting bar may extend between a first pad of the first columnar array and a first pad of the second columnar array.

The connecting bars may be directly connected to the first pads. The connecting bars may not be connected to the first pads at a junction with any other connections, for example tie bars.

The second columnar array may be rotated 180 degrees relative to the first columnar array.

It will be appreciated that the die paddles in the first and second columnar arrays may be the same. However, because the die paddles may comprise a first pad and a second pad, wherein the first pad and the second pad are not the same size, rotating the second columnar array by 180 degrees relative to the first columnar array results in the die paddles of the first and second columnar arrays being offset from one another. It will be appreciated that the same effect can be achieved by rotating the first columnar array by 180 degrees relative to the second columnar array.

Tie bars may be provided between the die paddles in the first columnar array and die paddles in the second columnar array.

Tie bars are connections formed from the same material as the die paddles that extend between die paddles in the first columnar array and the second columnar array. The tie bars may extend between edges of die paddles in the first columnar array and edges of the die paddles in the second columnar array that are adjacent. The tie bars help provide rigidity to the lead frame. During further manufacturing processes the tie bars may be cut so as to separate individual semiconductor assemblies.

A first width may be defined between adjacent edges of the first columnar array and the second columnar array; and
a second width may be defined between the adjacent first and second columnar arrays, wherein the second width may be smaller than the first width, and the second width may be between around 20 micrometres, µm, and around 100 µm.

That is to say that the second width is spaced apart from the edges of the first and second columnar arrays.

The second width may be referred to as a saw lane width. The saw lane width may be between around 20 µm and around 150 µm. The saw lane width may be between around 30 µm and around 75 µm. The saw lane width may be between around 30 µm and around 50 µm The saw lane width may be around 50 µm.

The lead frame may comprise a plurality of first columnar arrays and a plurality of second columnar arrays.

That is to say that the lead frame is made up of a number of first columnar arrays and a number of second columnar arrays. A first and second columnar array may together define a columnar array pair. The lead frame may comprise a plurality of columnar array pairs. The columnar array pairs may be connected to one another via connecting bars and/or tie bars. Die paddles in adjacent columnar array pairs may be offset from one another.

A first columnar array may be adjacent a second columnar array.

That is to say that when there are a plurality of first columnar arrays, and a plurality of second columnar array, the columnar arrays may be arranges such that a first columnar array is always adjacent a second columnar array. In other words, a first columnar array may not be adjacent to another first columnar array. In this way, adjacent columnar arrays are always offset from one another. Having adjacent columnar arrays always offset from one another helps to maximise the density of die paddles on the lead frame, by being able to reduce the width between adjacent columnar arrays.

The lead frame comprises around 0.986 die paddles per square mm.

That is to say that a lead frame may have a dimension of 53 mm by 185 mm, and because the saw lane width is reduced by having offset columns, 9672 die paddles may be provided on the lead frame.

According to a second aspect of the invention there is provided semiconductor assembly, comprising a lead frame according to the first aspect of the invention wherein a die is coupled to each die paddle.

The term die encompasses a semiconducting material. A circuit is then usually fabricated on the surface of the die. They die may be formed of silicon.

The optional and/or preferred features of the first aspect of the invention as set out herein are also applicable to the second aspect of the invention where appropriate.

Embodiments of the present invention will now be described, by way of example only, with reference to the accompanying drawings in which:
Figure 1 shows a plan view of part of a lead frame for use in the manufacture of a semiconductor assemblies;
Figure 2 shows a plan view of part of a lead frame according to an embodiment of the invention for use in the manufacture of semiconductor assemblies; and
Figure 3 shows a plan view of part of another lead frame according to an embodiment of the invention for use in the manufacture of semiconductor assemblies.

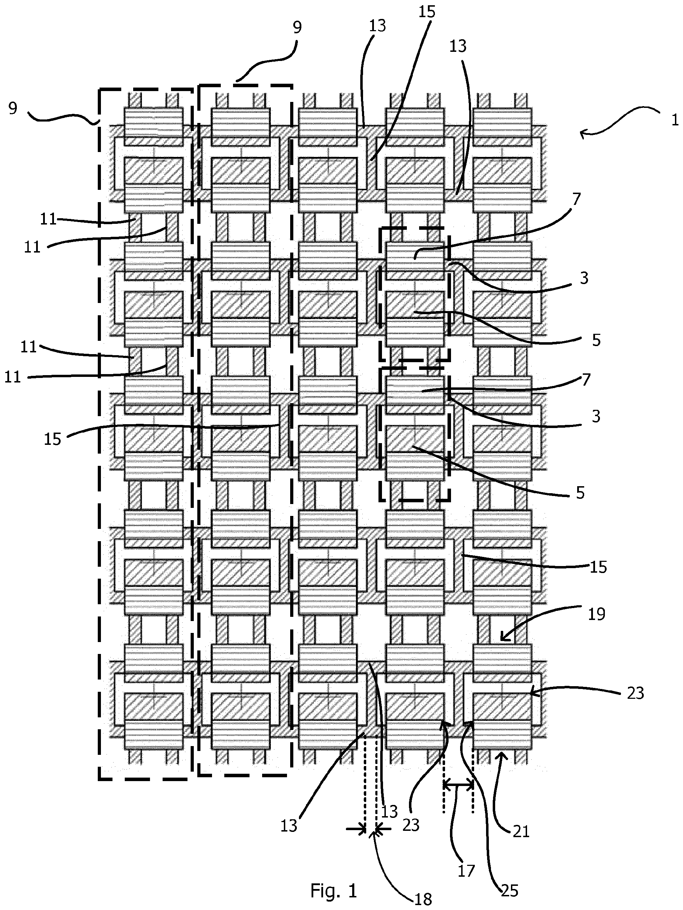

Figure 1 shows a plan view of part of a known lead frame 1 for use in the manufacture of a semiconductor assemblies. The lead frame 1 is effectively a sheet of material, with material having been selectively removed, for example by stamping or etching, in order to define a plurality of die paddles 3 (for ease only two die paddles are provided with the reference label 3). The sheet of material may be for example copper, copper alloy, or an iron nickel alloy.

The lead frame 1 may be described as a common lead frame.

Each die paddle 3 comprises a first larger pad 5 and a second smaller pad 7. The first pad 5 is larger, in that it has a larger surface area than the second pad 7. The first pad 5 is provided such that a die is received on the pad 5. Where a die is a piece of semiconducting material. The second pad 7 is provided so that connections to the first pad 5 and die can be subsequently made, as is well known in the art. In other embodiments, each die paddle 3 may comprise three or more pads. In particular, in some embodiments, the smaller pad 7 may comprise a plurality of smaller pads.

The part of the lead frame 1 of Figure 1 comprises five columnar arrays 9 of die paddles 3. For ease, only two columnar arrays 5 are labelled in Figure 1. Each columnar array 5 comprises a five die paddles 3. The die paddles 3 are arranged in a column in each columnar array 5. As such, the part of the lead frame 1 shown comprises a 5x5 array of die paddles. It will be appreciated that the number of die paddles 3 in each columnar array 9 may be much greater than 5, and likewise the lead frame 1 may comprise more than 5 columnar arrays. For example, the lead frame 1 may comprise around 7000 die paddles 3.

The die paddles 3 in a columnar array 9 are connected to each other with tie bars 11. The die paddles 3 are shown to be connected to adjacent die paddles 3 in the same columnar array 9 with two tie bars 11. However, in other embodiments adjacent die paddles 3 in the same columnar array 9 may be connected to one another with one tie bar 11, and in other embodiments, they may be connected to one another with three or more tie bars 11.

Further tie bars 13 project from the die paddles 3 to connect die paddles 3 in adjacent columnar arrays 9. Relative to the columnar arrays 9, it can be seen that the tie bars 11 which connect adjacent die paddles 3 in the same columnar array 9 extend in a direction that is generally parallel to the columnar arrays 9. Whereas, the tie bars 11 that connect die paddles 3 in adjacent columnar arrays extend in a direction that is generally perpendicular to the columns of the columnar arrays 9.

The perpendicularly extending tie bars 13, which connect die paddles 3 in adjacent columnar arrays 9, are connected to each other with connecting bars 15. The connecting bars 15 extend in a direction that is generally parallel with the columnar arrays 9 and the tie bars 11. The connecting bars 15 extend between adjacent perpendicularly extending tie bars 13. The connecting bars 15 provide additional rigidity to the lead frame 1. Because, as described above, the die paddles 3 are formed by removing material from a plate, the tie bars 11, 13 and in particular the connecting bars 15 are required to support the die paddles 3 and prevent the lead frame 1 from undergoing unacceptable warping and in the worst case braking during further manufacturing steps.

Each die paddle 3 ultimately goes on to form part of a single semiconductor assembly or package. In order to form the singular semiconductor assemblies or packages, the lead frame 1, at some point during a manufacturing process must be cut. The step of cutting the lead frame comprises sawing, specifically using a rotating saw blade. The lead frame 1 may be fed to the rotating saw blade. Put another way, the lead frame 1 and so columnar arrays 9 may be moved relative to the rotating saw blade. In other embodiments, the cutting operation maybe by way of a variety of different cutting processes including, but not limited to, a reciprocating or rotating blade (i.e. sawing), a laser, a waterjet or other similar process.

Each die paddle 3 may be considered to have a first side 19, a second side 21, a third side 23, and a fourth side 25. Where when looking at the plan view of Figure 1, the first side 19 is a top side, the second side 21 is a bottom side, the third side 23 is a right side, and the fourth side 25 is a left side. There is a first width 17 that is defined between adjacent columnar arrays 9. In particular, this width 17 is defined between adjacent edges of die paddles 3. That is to say that the width 17 is defined between a third side 23 of a die paddle 3 in one columnar array 9 and the fourth side 25 of a die paddle 3 in an adjacent columnar array 9. In addition, to the width 17, a further second width 18 is defined which is provided between adjacent columnar arrays 9 and may be referred to as the "saw lane width". The width 18 is wide enough for a saw or other suitable cutting tool to be able to cut through the tie bars 13 and connecting bars 15 that are between adjacent columnar arrays so as to remove the connecting bars 15, but narrow enough such that some encapsulate (material) remains at the die paddles 3 to provide protection of the die paddles 3 form a cutting tool and/or account for variations and tolerances when cutting. In other words, the saw lane width 18 is smaller than the width 17, yet wide enough to remove the connecting bars 15. Put another way, the saw lane width 18 is spaced apart from the edges of die paddles 3 in adjacent columnar arrays. The width 18 is further restricted by the amount of material that must be provided by the connecting bars 15 and the tie bars 13 to provide the necessary support to the lead frame 1 during manufacturing of the semiconductor assemblies. The saw lane width 18 is generally around 300 micrometres (µm). In some embodiments the saw lane width 18 may be around 150 µm. However, if the saw lane width 18 is smaller than this there is not enough material to provide the necessary mechanical support to the lead frame, and the lead frame may undergo unacceptable warping and/or break. Further, if the saw lane width 18 is narrower than the width of the connecting bars 15, or if the saw lane width is narrower than the width of the connecting bars 15 plus variations (tolerances) in cutting and manufacturing of the lead frame 1, it may not be possible to remove all of the material of the connecting bars 15, which would then result in undesirable electrical connections between adjacent die paddles 3 and result in failure of the assemblies.

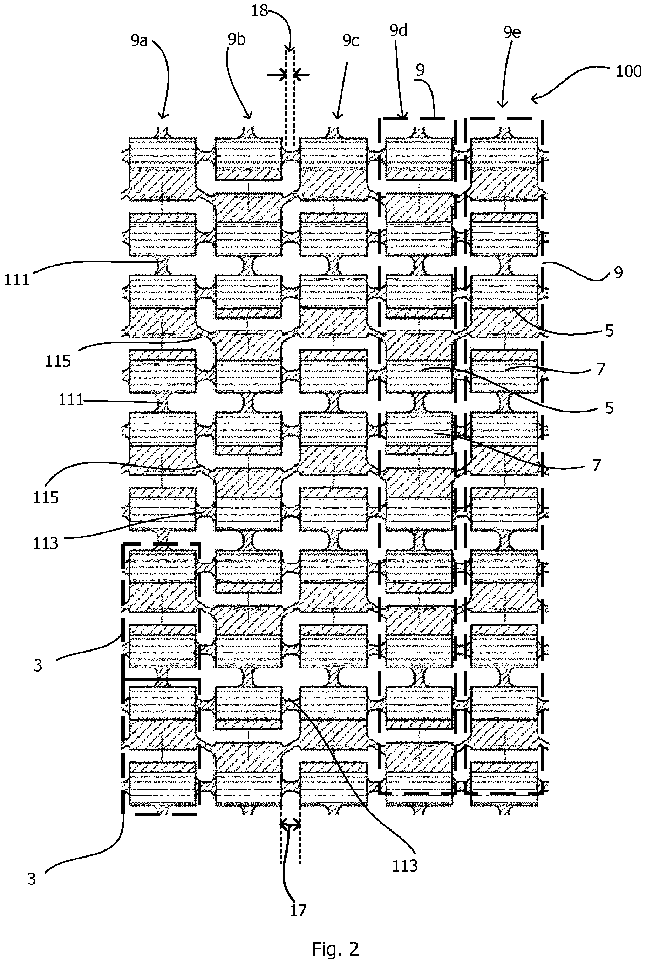

Turning to Figure 2, which shows a plan view of part of a lead frame 100 according to an embodiment of the invention for use in the manufacture of semiconductor assemblies. For ease of understanding the same reference numerals will be used for the same corresponding features in Figure 2 as those in Figure 1.

The lead frame 100 comprises a plurality of columnar arrays 9, each columnar array 9 comprises a plurality of die paddles 3. The lead frame 100 differs from the lead frame 1 in Figure 1 in that the die paddles 3 in adjacent columnar arrays are offset from each other. In particular, the lead frame 100 comprises five columnar arrays labelled 9a-e. The die paddles 3 in columnar array 9a are not aligned with the die paddles 3 in the adjacent columnar array 9b. Likewise, the die paddles 3 in columnar array 9b are not aligned with the die paddles 3 in either of the adjacent columnar arrays 9a, 9c. Whereas in Figure 1, it is clear that the die paddles 3 in adjacent columnar arrays are aligned. By way of example in Figure 1 the first pad 5 is aligned with an adjacent first pad 5 in an adjacent columnar array 9, and likewise the second pad 7 is aligned with an adjacent second pad 7 in an adjacent columnar array 9.

In contrast, it can be seen in Figure 2 that a first pad 5 is not aligned with any first pads 5 in adjacent columnar arrays 9, and likewise a second pad 7 is not aligned with any second pads in adjacent columnar arrays 9.

As with Figure 1, the lead frame 100 shown in Figure 2 is a 5x5 array, it will be appreciated that in other embodiments, the lead frame 100 may comprise more than 5 columnar arrays 9 and each columnar array 9 may comprise more than 5 die paddles 3.

In other embodiments, each die paddle 3 may comprise three or more pads. In particular, in some embodiments, the smaller pad 7 may comprise a plurality of smaller pads.

In the embodiment shown in Figure 2, adjacent columnar arrays 9 are offset from one another by being rotated 180 degrees. That is to say that the columnar array 9b is rotated 180 degrees relative to the columnar array 9a. Likewise, columnar array 9c is rotated 180 degrees relative to columnar array 9b. It will be appreciated that columnar array 9c is aligned with columnar array 9a, but columnar array 9c is not adjacent to columnar array 9a.

As with the die paddles 3 in the lead frame 1 of Figure 1, the die paddles 3 in the lead frame 100 in the same columnar array 9 are connected to each other with tie bars 111. The tie bars 111 serve the same purpose as the tie bars 11 in Figure 1, in that they provide a mechanical connection between adjacent die paddles 3 in the same columnar array 9 and provide structure and support to the lead frame 100. However, connecting bars 115 are also required to provide mechanical connections between die paddles 3 in adjacent columnar arrays 9. Due to the die paddles 3 in adjacent columnar arrays 9 being offset the connecting bars 115 extend in a generally diagonal direction relative to the columnar arrays 9. That is to say that the connecting bars 115 extend in a direction that is non-parallel with and non-perpendicular with the columnar arrays 9. In other words, the connecting bars 115 are inclined relative to the columnar arrays 9.

In the embodiment shown in Figure 2 only one tie bar 111 is shown extending between adjacent die paddles 3 in the same columnar array 9. In other embodiments, two or more tie bars 111 may be provided between adjacent die paddles 3 in the same columnar array 9.

As with the embodiment shown in Figure 1, the lead frame 100 in Figure 2 also comprises tie bars 113 which extend in a direction generally perpendicular to the columnar arrays 9.

The connecting bars 115 extending diagonally between die paddles 3 in adjacent columnar arrays 9 is advantageous because they provide strong, secure and rigid mechanical connections which mitigate against warping and/or breaking of the lead frame. In some embodiments, the connecting bars may extend in a direction that is perpendicular with the columnar arrays, particularly when the die paddles are large, in these instances the connecting bars still provide a strong, secure and rigid mechanical connection, whilst still being able to benefit from a narrower saw lane due to the die paddles in adjacent columnar arrays being offset.

The connecting bars 115 extend directly between the first pads 5 of die paddles 3 in adjacent columnar arrays 9. That is to say the connecting bars 115 are not connected to the die paddles 3 via an intermediate connection such as a tie bar 11, 13. The connecting bars 11, 13 do not form or meet at a connection with any other connections such as tie bars 11, 13. In other embodiments the connecting bars 115 may extend between only the second pads 7 of die paddles in adjacent columnar arrays 9, or they may extend between first 5 and second pads 7 in adjacent columnar arrays 9 or any suitable combination dependent upon how the die paddles 3 in adjacent columnar arrays are offset from another. The connecting bars 115 in other embodiments may be connected to the die paddles via intermediate connections such as tie bars 11, 13.

The connecting bars 115 extending at an incline to the columnar arrays 9 has another advantage in that the length of the saw lane width 18 is reduced. The saw lane width 18 may be around 20 micrometres (µm) to 50 micrometres (µm). The saw lane width 18 may be around 20 micrometres (µm). The saw lane width 18 may be around 30 micrometres (µm). The saw lane width 18 may be around 50 micrometres (µm). The saw lane width 18 may be limited by the cutting tool used to separate the die paddles in a later manufacturing process.

In reducing the saw lane width 18 between each columnar array for a lead frame 100 produced from a given sized plate of material more die paddles 3 can be provided on the lead frame 100 and less material is wasted. By way of example, for a lead frame 1 (as shown in Figure 1) with connecting bars that are generally parallel with the columnar arrays produced from a plate of material with dimensions of 53 mm by 185 mm, and a having a saw lane width 18 of 150 µm may comprise around 7776 die paddles (i.e. 0.793 die paddles per square mm). In contrast, a lead frame 100 (as shown in Figure 2) also produced from a plate of material with dimensions of 53 mm by 185 mm and having a saw lane width 18 of 50 µm, the lead frame 100 can comprise 9672 die paddles (i.e. 0.986 die paddles per square mm). This is an increase of 24%. Accordingly, the density of die paddles 3 provided on a lead frame is increased, while at least retaining and if not improving the rigidity of the lead frame.

As described above, the die paddles 3 in adjacent columnar arrays 9 being offset from one another is achieved by rotating the columnar array 180 degrees relative to adjacent columnar arrays 9. In other embodiments, the die paddles 3 may be offset in adjacent columnar arrays 9 by simply translating adjacent columnar arrays 9 in a direction that is generally parallel with the columnar arrays 9 and/or by rotation of the columnar arrays 9 as already described.

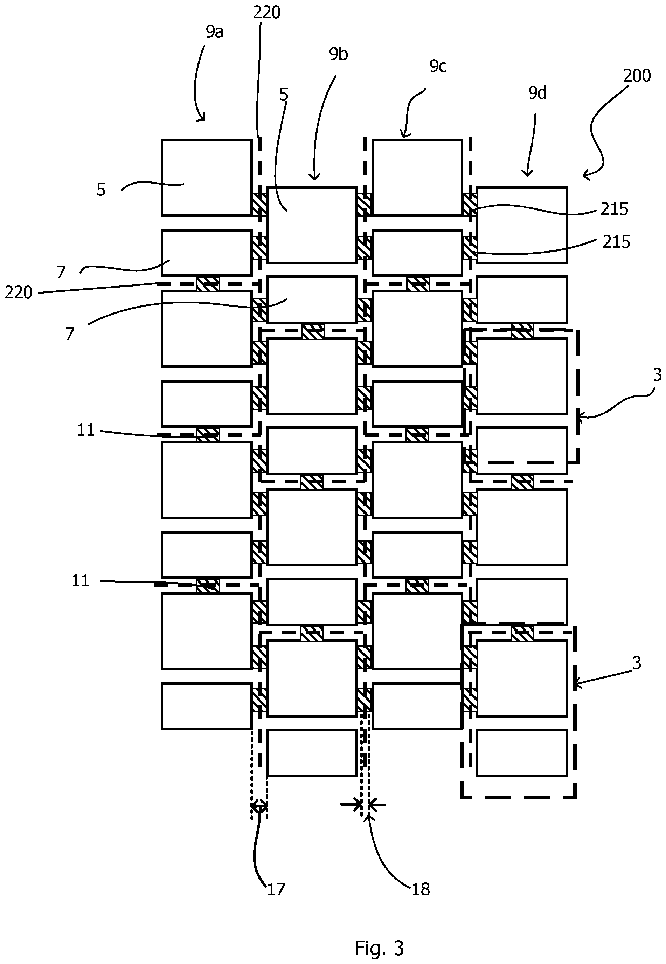

Turning to Figure 3. Figure 3 shows a plan view of part of another lead frame 200 according to an embodiment of the invention for use in the manufacture of semiconductor assemblies.

The part of the lead frame 200 shown comprises four columnar arrays 9a, 9b, 9c, 9d, and each columnar array 9 comprises four die paddles 3. It will of course be appreciated that only part of the lead frame 200 is shown and that the lead frame 200 may comprise more than four columnar arrays 9 and each columnar array may comprise more than four die paddles 3.

The lead frame 200 is similar to the lead frame 100 shown in Figure 2 in that die paddles 3 in adjacent columnar arrays 9 are offset from one another. That is to say that die paddles 3 in columnar array 9b are not aligned with die paddles 3 in the adjacent columnar arrays 9a, 9c. In particular, in Figure 3 a first pad 5 is not aligned with any first pads 5 in adjacent columnar arrays 9, and likewise a second pad 7 is not aligned with any second pads in adjacent columnar arrays 9.

The lead frame 200 differs from the lead frame 100 in Figure 2 in that the die paddles 3 in adjacent columnar arrays 9 are offset by translating the columnar arrays 9, in a direction parallel to the columnar arrays 9 (rather than by rotation through 180 degrees).

The die paddles 3, as with the die paddles in Figure 1 and Figure 2 are connected to each other with tie bars 11, 13. The lead frame 200 also comprises connecting bars 215. The connecting bars 215 extend in a direction that is generally perpendicular to the columnar arrays 9 and tie bars 11. The connecting bars 215 provide support and rigidity to the lead frame 200. Because the die paddles 3 in adjacent columnar arrays 9 are offset, the width of the connecting bars 215, and hence the saw lane width 18 can be reduced. Thus the density of die paddles 3 provided on a given sized lead frame 200 is increased.

In later manufacturing steps, in order to separate the die paddles 3 from the lead frame 200, the tie bars 11 and connecting bars may be cut along the cut lines 220. The tie bars 11 may be cut with a laser, as this may be more efficient given that there is not a continuous path across columnar arrays 9 that a saw blade can readily pass along. The connecting bars 215 may be cut with a saw or a laser. Nevertheless, the tie bars 11 and the connecting bars 215 may be cut with any suitable cutting tool or means.

The lead frames 1, 100, 200 shown in Figures 1 to 3 are for leadless (or lead free, or flat no-lead) semiconductor packages. It will be appreciated, the lead frames 100, 200 may be adapted for other types of semiconductor assemblies or packages that do comprise leads, arms, connectors, etc.

## Claims

1. A lead frame for a semiconductor assembly, the lead frame comprising a first columnar array of die paddles and a second columnar array of die paddles;
wherein the die paddles in the first columnar array are offset from the die paddles in the second columnar array.

2. The lead frame according to claim 1, wherein each die paddle comprises a first pad and a second pad, the first pad being larger than the second pad, and wherein the first pads in the first columnar array are offset from the first pads in the second columnar array.

3. The lead frame according to any claim 1 or claim 2, wherein each die paddle in the first columnar array is connected to a die paddle in the second columnar array with a connecting bar.

4. The lead frame according to claim 3, wherein the connecting bars extend in a direction generally perpendicular to the first and second columnar arrays.

5. The lead frame according to claim 3, wherein the connecting bars extend in a non-parallel and non-perpendicular direction relative to the first and second columnar arrays.

6. The lead frame according to any of claim 5, wherein each connecting bar extends between a first pad of the first columnar array and a first pad of the second columnar array.

7. The lead frame according to any preceding claim wherein the second columnar array is rotated 180 degrees relative to the first columnar array.

8. The lead frame according to any preceding claim, wherein tie bars are provided between the die paddles in the first columnar array and die paddles in the second columnar array.

9. The lead frame according to any preceding claim, wherein a first width is defined between adjacent edges of the first columnar array and the second columnar array; and
a second width is defined between the adjacent first and second columnar arrays, wherein the second width is smaller than the first width, and the second width is between around 20 micrometres, µm, and around 100 µm.

10. The lead frame according to any preceding claim, wherein the lead frame comprises a plurality of first columnar arrays and a plurality of second columnar arrays.

11. The lead frame according to claim 10, wherein a first columnar array is always adjacent a second columnar array.

12. A semiconductor assembly, comprising a lead frame according to any preceding claim, wherein a die is coupled to each die paddle.
